# EUROPÄISCHE PATENTSCHRIFT

(11) **EP 3 499 243 B1**
(45) Veröffentlichungstag und Bekanntmachung des Hinweises auf die Patenterteilung: **03.03.2021**
(21) Anmeldenummer: 18206994.8
(22) Anmeldetag: 19.11.2018
(51) Int. Cl.: G01P 15/08, H02B 1/54, H02J 13/00, H02J 50/10, G01R 31/50, H02J 50/70

(54) **VORRICHTUNG ZUR ÜBERWACHUNG EINER STROMFÜHRENDEN EINRICHTUNG**
DEVICE FOR MONITORING A CURRENT-CARRYING DEVICE
DISPOSITIF DE SURVEILLANCE D'UN DISPOSITIF CONDUCTEUR

(30) Priorität: 13.12.2017 DE 102017129758
(43) Veröffentlichungstag der Anmeldung: 19.06.2019
(73) Patentinhaber: SDA-engineering GmbH, 52134 Herzogenrath (DE)
(72) Erfinder: Renault, Philippe L. A., 52428 Jülich (DE)
(74) Vertreter: Wagner Albiger & Partner Patentanwälte mbB

(56) Entgegenhaltungen:
- WO-A1-2017/035548
- CN-B- 103 326 468
- DE-A1-102011 003 308

## Beschreibung

Die Erfindung betrifft eine Vorrichtung zur Überwachung einer stromführenden Einrichtung, umfassend mindestens einen Beschleunigungssensor zur Erzeugung von Beschleunigungsmesswerten, eine Kommunikationseinheit zur Übermittlung der erzeugten Beschleunigungsmesswerte und eine Stromversorgungseinheit für den mindestens einen Beschleunigungssensor und die Kommunikationseinheit.

Zur Messung von seismisch oder dynamisch verursachten Bewegungen werden häufig Geschwindigkeits- oder Beschleunigungsmess-Sensoren verwendet. Damit ist es beispielsweise möglich, eine stromführende Einrichtung, zum Beispiel einen Transformator in einer Umspannstation zu überwachen und bei Erreichen eines voreinstellbaren gemessenen Grenzwertes der Beschleunigungsmesswerte einen Alarm über die Kommunikationseinheit an eine entfernte Steuerzentrale zu übermitteln, um zum Beispiel beim Auftreten von Erdstößen eine automatische Abschaltung der überwachten stromführenden Einrichtung herbeizuführen. Dies ist beispielsweise in Gebieten mit hoher Erdbebengefahr gefordert.

Aus der CN 1 03 326 468 B ist eine gattungsgemäße Überwachungseinrichtung für ein Energieversorgungsnetz aus Überlandleitungen mit mehreren Sensoren für Umgebungseinflüsse sowie Kommunikationseinrichtungen bekannt, die induktiv über eine Ladespule auf der Überlandleitung mit Betriebsspannung versorgt werden. Das Anbringen von Ladespulen auf der Überlandleitung setzt eine entsprechende Zugänglichkeit der Überlandleitung voraus und bedingt einen hohen Montageaufwand, der auch die vorübergehende Abschaltung der stromführenden Einrichtung bei der Montage aus Sicherheitsgründen erfordert. Dies ist verbesserungswürdig.

Die DE 689 20 198 T2 offenbart ein Abnormitäts-Diagnosesystem für eine Hochspannungsanlage mit einem Beschleunigungssensor zur Erzeugung von Beschleunigungsmesswerten und einer Kommunikationseinheit zur Übermittlung der erzeugten Beschleunigungsmesswerte, die über eine Stromversorgungseinheit gespeist werden. Ein elektrischer Anschluss derselben mit entsprechendem Installationsaufwand ist erforderlich.

Aus der CN 1 07 749 672 A ist ein System zur Energiewandlung aus einem hochfrequenten Wechselfeld mittels einer Induktionsplatte und einer Leiterschleife bekannt.

Die WO 2010/136 052 A1 offenbart einen elektrotechnischen Verbraucher, der seine Energie aus dem Streufeld eines Elektromotors bezieht.

Aus der DE 10 2011 003308 A1 ist eine Einrichtung zur Überwachung einer elektrischen Leitung mittels Sensoren und mit einer induktiven Stromversorgung der Sensoren bekannt.

Die WO 2017/035548 A1 bezieht sich auf ein Betriebsgerät für Leuchtmittel mit einem Transformator und einer induktiven Spannungsversorgung für eine elektrische Schaltung.

Aufgabe der Erfindung ist es, eine Vorrichtung der eingangs genannten Art vorzuschlagen, die auf einfachste Weise installierbar ist und völlig autonom betrieben werden kann.

Zur Lösung der gestellten Aufgabe wird erfindungsgemäß die Ausgestaltung einer Vorrichtung zur Überwachung einer stromführenden Einrichtung gemäß den Merkmalen des Patentanspruchs 1 vorgeschlagen.

Vorteilhafte Ausgestaltungen und Weiterbildungen der Erfindung sind Gegenstand der abhängigen Ansprüche.

Die Erfindung schlägt vor, dass die Stromversorgungseinheit eine Induktionsplatte aus einem metallischen Werkstoff und eine um die Induktionsplatte verlaufende Leiterschleife umfasst, mittels derer die Stromversorgung für den mindestens einen Beschleunigungssensor und die Kommunikationseinheit sowie gegebenenfalls weitere Bestandteile der erfindungsgemäßen Vorrichtung ausschließlich durch Induktion aus einem elektromagnetischen Wechselfeld der stromführenden Einrichtung erzeugbar ist und die Vorrichtung in einem geschlossenen Gehäuse mit Gehäusewandung angeordnet ist, wobei die Induktionsplatte zumindest einen Teilbereich der Gehäusewandung ausbildet.

Erfindungsgemäß ist es damit möglich, die gesamte in einem geschlossenen Gehäuse angeordnete Vorrichtung als kompakte Baueinheit in der Nähe der zu überwachenden stromführenden Einrichtung, beispielsweise einem Transformator einer Umspannstation zu positionieren, woraufhin die Vorrichtung aufgrund des vorhandenen elektromagnetischen Wechselfeldes um die stromführende Einrichtung unmittelbar die für den Betrieb erforderliche elektrische Energie aus dem Wechselfeld erzeugt. Einer zusätzlichen Verdrahtung der Vorrichtung mit Zufuhrleitungen für die Betriebsspannung und/oder der Errichtung zusätzlicher Energiequellen, wie einer Photovoltaikanlage bedarf es erfindungsgemäß nicht. Es genügt, die Vorrichtung im Wirkbereich des elektromagnetischen Wechselfeldes der zu überwachenden stromführenden Einrichtung zu platzieren, woraufhin diese selbsttätig und völlig autark mit der benötigten Energieerzeugung beginnt und den Betrieb zur Überwachung der stromführenden Einrichtung aufnimmt.

Die erfindungsgemäße Vorrichtung kann sehr kompakt ausgebildet werden und verfügt über Komponenten, die nur einen äußerst niedrigen Stromverbrauch aufweisen, um den über die elektromagnetische Induktion gewonnenen Betriebsstrom möglichst effizient und ohne Unterbrechung auszunutzen.

Die erfindungsgemäße Vorrichtung eignet sich aufgrund der Selbstversorgung mit Strom aus den in der näheren Umgebung vorhandenen elektromagnetischen Feldern zum Einsatz überall dort, wo keine externe Stromquelle zur Verfügung steht und/oder keine Kabel verlegt werden können.

Nach einem Vorschlag der Erfindung ist die Leiterschleife lediglich einfach um die Induktionsplatte verlaufend angeordnet, wobei die Leiterschleife generell als mit offenen Enden ausgeführt sein sollte, an denen die Betriebsspannung für die Komponenten der Vorrichtung abgegriffen werden kann. Die Induktionsplatte verstärkt den magnetischen Fluss und erlaubt die Induktion in die lediglich in einer großen Schleife geführte Leiterschleife.

Die Leiterschleife ist nach einem weiteren Vorschlag der Erfindung auf Basis eines Silber- oder Kupferleiters ausgeführt.

Nach einem weiteren Vorschlag der Erfindung sind insgesamt drei Beschleunigungssensoren vorgesehen, die räumlich orthogonal zueinander angeordnet sind, um Beschleunigungen in allen drei Raumrichtungen gleichermaßen erfassen und auswerten zu können.

Zur weiteren Steigerung der Betriebssicherheit kann die Stromversorgungseinheit der erfindungsgemäßen Vorrichtung nach einem weiteren Vorschlag der Erfindung auch eine Pufferbatterie mit zugehörigem Laderegler aufweisen, die ebenfalls von der Induktionsplatte und der um diese verlaufende Leiterschleife induktiv geladen wird. Die Pufferbatterie dient primär der kurzfristigen Überbrückung sowie zur Spannungsstabilisierung.

Um die von den Beschleunigungssensoren gewonnenen Beschleunigungsmesswerte zu archivieren und wahlweise lediglich in gewissen Zeitabständen auszulesen oder für eine spätere Übermittlung zwischenzuspeichern, ist nach einem weiteren Vorschlag der Erfindung ein Datenspeicher zur Speicherung der Beschleunigungsmesswerte vorgesehen. Ein solcher Datenspeicher kann beispielsweise von einer handelsüblichen Speicherkarte gebildet werden.

Die Kommunikationseinheit der erfindungsgemäßen Vorrichtung kann je nach Situation Schnittstellen für eine drahtgebundene und oder drahtlose Kommunikation aufweisen. Beispielsweise können für den Aufbau einer externen kabelgebundenen Datenverbindung RJ 45-Buchsen oder auch ein USB Anschluss vorhanden sein, wohingegen für eine drahtlose Kommunikation zum Beispiel eine GPRS/LTE Mobilfunkeinheit oder ein WLAN Sender mit entsprechender Antenne an der Vorrichtung vorgesehen sein kann.

Insbesondere kann die Kommunikation drahtlos über LTE-Narrowband extrem energiesparend und mit sehr guter Netzabdeckung sowie hohem Signalpegel durchgeführt werden, um auch eine Kommunikation durch Stahlbetonwände und -decken sowie aus Kellerräumen und dergleichen mehr zu ermöglichen.

Die Beschleunigungssensoren werden im Hinblick auf einen möglichst geringen Raumbedarf sowie geringen Energieverbrauch vorzugsweise von MEMS-Typen gebildet, wie sie beispielsweise auch in Smartphones integriert sind und die über einen äußerst geringen Stromverbrauch von nur wenigen mA sowie eine Betriebsspannung ≤ 5 V verfügen.

Die Ausgestaltungen und Einzelheiten der Erfindung werden nachfolgend anhand der ein Ausführungsbeispiel darstellenden Zeichnung erläutert.

Die einzige Figur zeigt in einer schematisierten Darstellung eine Vorrichtung 1, die beispielsweise zur Überwachung einer stromführenden Einrichtung in Form eines Transformators eingesetzt werden kann, der ein starkes elektromagnetisches Wechselfeld in seiner näheren Umgebung erzeugt. In dieser näheren Umgebung wird die Vorrichtung 1 platziert, sodass sie im Einflussbereich dieses Wechselfeldes steht.

Die Vorrichtung 1 weist ein allseits geschlossenes Gehäuse 10 mit Gehäusewandungen 100 auf, innerhalb dessen die nachfolgend erläuterten Baugruppen geschützt vor Umgebungseinflüssen angeordnet sind.

So umfasst die Vorrichtung 1 drei in einem orthogonalen Verhältnis zueinander angeordnete Beschleunigungssensoren 11, die als Messwertaufnehmer dynamisch oder seismisch verursachte Bewegungen, zum Beispiel Erdstöße, in allen drei Raumrichtungen registrieren und entsprechende Beschleunigungsmesswerte generieren.

Darüber hinaus umfasst die Vorrichtung 1 einen Datenspeicher 12 in Form einer handelsüblichen Speicherkarte sowie eine Anschlussbuchse 13 zum Anschluss von Kommunikationsleitungen sowie ein GPRS/LTE Modul als Kommunikationseinheit 15 zur drahtlosen Übermittlung der von den Beschleunigungssensoren 11 ermittelten Beschleunigungsmesswerte über eine Antenne 18. Sowohl die drahtgebundene Anschlussbuchse 13 als auch die drahtlose Kommunikation über das GPRS/LTE Modul der Kommunikationseinheit 15 und die Antenne 18 erfolgen zu einer entfernt gelegenen Überwachungseinrichtung, die die Messwerte der Beschleunigungssensoren 11 auswertet und zum Beispiel beim Auftreten eines Erdstoßes eine automatische Abschaltung der überwachten stromführenden Einrichtung bewirkt.

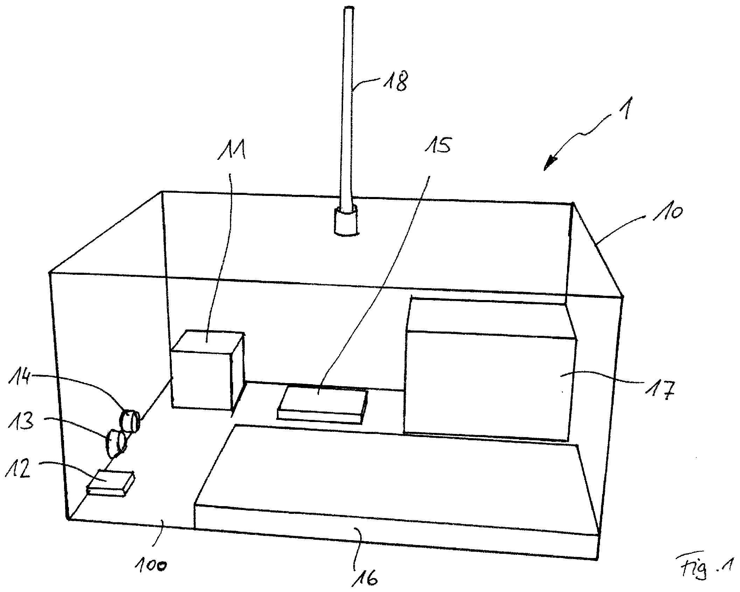

Zum Betrieb der Beschleunigungssensoren 11 sowie der weiteren im Innern des Gehäuses 10 aufgenommenen Bauteile der Vorrichtung, d. h. des GPRS/LTE Moduls 15, des Datenspeichers 12 sowie der nachfolgend noch erläuterten Pufferbatterie 17 ist eine Induktionsplatte 16 aus metallischem Material vorgesehen, um die ein nicht näher dargestellter elektrischer Leiter in Form eines Silber- oder Kupferdrahts in einer großen Schleife verlegt ist. Die Induktionsplatte 16 ist Teil der in der Darstellung gemäß Figur 1 im Bodenbereich angeordneten Gehäusewandung 100.

Sobald das Gehäuse 1 in den Wirkungsbereich des elektromagnetischen Wechselfeldes der zu überwachenden stromführenden Einrichtung gelangt, in dem es zum Beispiel in unmittelbarer Nähe aufgestellt wird, erfolgt durch Induktion aus dem Wechselfeld in die um die Induktionsplatte 16 verlaufende Leiterschleife eine vollständig autarke Erzeugung der für den Betrieb der Vorrichtung 1 erforderlichen und vorangehend aufgeführten Bauteile. Dabei werden aus der Leiterschleife über Induktion aus dem Wechselfeld nicht nur die Beschleunigungssensoren 11, die Kommunikationseinheit 15 sowie der Datenspeicher 12 mit der erforderlichen Betriebsspannung versorgt, sondern es wird auch eine Pufferbatterie 17 über einen entsprechenden, hier jedoch nicht gesondert dargestellten Laderegler geladen, die kurzfristige Ausfälle der induktiven Stromerzeugung überbrückt und die anliegende Spannung aus der Leiterschleife stabilisiert.

Es versteht sich, dass anstelle der drahtlosen Übermittlung der Messwerte auch eine kabelgebundene Übermittlung durch Anschluss an der hierfür vorgesehenen Buchse 13 erfolgen kann.

Sofern eine externe Stromversorgung zur Verfügung steht, kann überdies über eine entsprechende Anschlussbuchse 14 auch die benötigte Betriebsspannung unter Umgehung der induktiven Energiegewinnung eingespeist werden.

Aufgrund der vorangehend dargestellten Fähigkeit der Vorrichtung 1, die zum Betrieb erforderliche Betriebsspannung selbsttätig aus dem im Umfeld der zu überwachenden stromführenden Einrichtung vorhandenen elektromagnetischen Wechselfeld durch Induktion zu erzeugen, kommt die Vorrichtung 1 jedoch im Normalfall ohne externe Stromversorgung aus.

Es ist lediglich erforderlich, die Vorrichtung 1, die in einem kompakten Gehäuse 10 angeordnet ist, in der Nähe der zu überwachenden stromführenden Einrichtung aufzustellen, woraufhin sie unmittelbar in Betrieb geht. Der Installationsaufwand wird damit auf das absolute Minimum reduziert.

Neben der Überwachung eines Transformators kommen auch beliebige andere Aggregate und Leitungsabschnitte als stromführende Einrichtung in Betracht, die mit ausreichend großem (Stark-) Strom durchflossen sind und ein entsprechendes Wechselfeld erzeugen.

## Patentansprüche

1. Vorrichtung zur Überwachung einer Starkstrom führenden Einrichtung, umfassend mindestens einen Beschleunigungssensor (11) zur Erzeugung von Beschleunigungsmesswerten, eine Kommunikationseinheit (15) zur Übermittlung der erzeugten Beschleunigungsmesswerte und eine Stromversorgungseinheit für den mindestens einen Beschleunigungssensor (11) und die Kommunikationseinheit (15), wobei die Stromversorgungseinheit eine Induktionsplatte (16) aus einem metallischen Werkstoff und eine um die Induktionsplatte (16) verlaufende Leiterschleife umfasst, die die Stromversorgung der Vorrichtung ausschließlich durch Induktion aus einem elektromagnetischen Wechselfeld der stromführenden Einrichtung ohne zusätzliche Energiequellen bereitstellt und die Vorrichtung (1) in einem geschlossenen Gehäuse (10) mit Gehäusewandung (100) angeordnet ist, wobei die Induktionsplatte (16) zumindest einen Teilbereich der Gehäusewandung (100) ausbildet.

2. Vorrichtung nach Anspruch 1, **dadurch gekennzeichnet, dass** die Leiterschleife einfach um die Induktionsplatte (16) verlaufend angeordnet ist.

3. Vorrichtung nach Anspruch 1 oder 2, **dadurch gekennzeichnet, dass** die Leiterschleife auf Basis von Silber oder Kupfer gebildet ist.

4. Vorrichtung nach einem der Ansprüche 1 bis 3, **dadurch gekennzeichnet, dass** drei Beschleunigungssensoren (11) vorgesehen sind, die räumlich orthogonal zueinander angeordnet sind.

5. Vorrichtung nach einem der Ansprüche 1 bis 4, **dadurch gekennzeichnet, dass** die Stromversorgungseinheit eine Pufferbatterie (17) mit Laderegler aufweist.

6. Vorrichtung nach einem der Ansprüche 1 bis 5, **dadurch gekennzeichnet, dass** ein Datenspeicher (12) zur Speicherung der Beschleunigungsmesswerte vorgesehen ist.

7. Vorrichtung nach einem der Ansprüche 1 bis 6, **dadurch gekennzeichnet, dass** die Kommunikationseinheit (15) Schnittstellen (13, 18) für eine drahtgebundene und/oder drahtlose Kommunikation aufweist.

8. Verwendung der Vorrichtung (1) gemäß einem der vorangehenden Ansprüche zur Überwachung einer als Transformator ausgebildeten stromführenden Einrichtung.

## Claims

1. An apparatus for monitoring a heavy current-carrying device, the apparatus comprising at least one acceleration sensor (11) producing acceleration measurement values, a communication device (15) transmitting produced acceleration measurement values, and a power supply unit for the at least one acceleration sensor (11) and the communication device (15), wherein the power supply unit includes an induction plate (16) of a metallic material and a conductor loop extending around the induction plate (16) to produce a power supply for the apparatus exclusively through induction from an electromagnetic alternating field of the heavy current-carrying device without additional energy sources and the apparatus (1) is arranged in a closed housing (10) having a housing wall (100), wherein the induction plate (16) is at least a subregion of the housing wall (100).

2. The apparatus according to claim 1, **characterized in that** the conductor loop is simply arranged to extend around the induction plate (16).

3. The apparatus according to claim 1 or 2, **characterized in that** the conductor loop is silver-based or copper-based.

4. The apparatus according to any of claims 1 to 3, **characterized in that** three acceleration sensors (11) are positioned orthogonally with respect to one another in space.

5. The apparatus according to any of claims 1 to 4, **characterized in that** the power supply unit comprises a buffer battery (17) with a charging regulator.

6. The apparatus according to any of claims 1 to 5, **characterized in that** a data memory (12) is provided for storing the acceleration measurement values.

7. The apparatus according to any of claims 1 to 6, **characterized in that** the communication device (15) has interfaces (13, 18) for a wired and/or a wireless communication.

8. A use of the apparatus (1) according to any of the preceding claims for monitoring the current-carrying device embodied as a transformer.

## Revendications

1. Dispositif pour surveiller un dispositif conduisant un courant de haute intensité, comprenant au moins un capteur d'accélération (11) pour la génération de valeurs mesurées d'accélération, une unité de communication (15) pour la transmission des valeurs mesurées d'accélération générées et une unité d'alimentation en courant pour le au moins un capteur d'accélération (11) et l'unité de communication (15), dans lequel l'unité d'alimentation en courant comprend une plaque à induction (16) composée d'un matériau métallique et une boucle conductrice, s'étendant autour de la plaque à induction (16), qui fournit l'alimentation en courant du dispositif exclusivement par induction à partir d'un champ alternatif électromagnétique du dispositif conduisant du courant sans sources d'énergie supplémentaires et le dispositif (1) est disposé dans un boîtier (10) fermé à paroi de boîtier (100), dans lequel la plaque à induction (16) réalise au moins une zone partielle de la paroi de boîtier (100) .

2. Dispositif selon la revendication 1, **caractérisé en ce que** la boucle conductrice est simplement disposée de manière à s'étendre autour de la plaque à induction (16).

3. Dispositif selon la revendication 1 ou 2, **caractérisé en ce que** la boucle conductrice est formée à base d'argent ou de cuivre.

4. Dispositif selon l'une quelconque des revendications 1 à 3, **caractérisé en ce que** trois capteurs d'accélération (11) sont prévus, qui sont disposés dans l'espace de manière perpendiculaire les uns aux autres.

5. Dispositif selon l'une quelconque des revendications 1 à 4, **caractérisé en ce que** l'unité d'alimentation en courant présente une batterie tampon (17) à régulateur de charge.

6. Dispositif selon l'une quelconque des revendications 1 à 5, **caractérisé en ce qu'**une mémoire de données (12) est prévue pour la mise en mémoire des valeurs mesurées d'accélération.

7. Dispositif selon l'une quelconque des revendications 1 à 6, **caractérisé en ce que** l'unité de communication (15) présente des interfaces (13, 18) pour une communication filaire et/ou sans fil.

8. Utilisation du dispositif (1) selon l'une quelconque des revendications précédentes pour la surveillance d'un système conducteur de courant réalisé sous la forme d'un transformateur.
